# EUROPEAN PATENT SPECIFICATION

(11) **EP 0 550 894 B1**
(45) Date of publication and mention of the grant of the patent: **04.08.1999**
(21) Application number: 92122009.1
(22) Date of filing: 24.12.1992
(51) Int. Cl.: H01L 27/108

(54) **Trench DRAM cell array**
Matrix von Graben-DRAM-Zellen
Réseau de cellules DRAM à sillon

(30) Priority: 09.01.1992 US 819159; 09.01.1992 US 818668
(43) Date of publication of application: 14.07.1993
(73) Proprietor: International Business Machines Corporation, Armonk, NY 10504 (US)
(72) Inventor: Bronner, Gary Bela, Mount Kisco, New York 10549 (US); Dhong, Sang Hoo, Mahopac, New York 10541 (US); Hwang, Wei, Armonk, New York 10504 (US); Park, Jong Woo, Essex Junction, Vermont 05452 (US); Voldman, Steven Howard, Burlington, Vermont 05401 (US)
(74) Representative: Schäfer, Wolfgang, Dipl.-Ing.

(56) References cited:
- EP-A- 0 224 213
- EP-A- 0 384 396
- GB-A- 2 199 695
- US-A- 4 967 248
- US-A- 5 021 852
- PATENT ABSTRACTS OF JAPAN vol. 14, no. 175 (E-914)(4118) 6 April 1990 & JP-A-2 028 367 ( HITACHI LTD ) 30 January 1990
- PATENT ABSTRACTS OF JAPAN vol. 13, no. 218 (E-761)(3566) 22 May 1989 & JP-A-1 030 259 ( FUJITSU LTD ) 1 February 1989
- PATENT ABSTRACTS OF JAPAN vol. 14, no. 278 (E-941)(4221) 15 June 1990 & JP-A-2 087 571 ( HITACHI LTD ) 28 March 1990
- PATENT ABSTRACTS OF JAPAN vol. 13, no. 232 (E-765)(3580) 29 May 1989 & JP-A-1 039 057 ( NEC CORP ) 9 February 1989

## Description

This invention relates to semiconductor memory devices and particularly to high density dynamic random access memory cells and methods for their manufacture in sub-micron technologies.

Designers of technologies for producing semiconductor devices have been continually pressured to increase effective device densities in order to remain cost and performance competitive. As a result, VLSI and ULSI technologies have entered the sub-micron realm of structural dimensions and now are designing technologies in the deep submicron feature size range. In the foreseeable future absolute atomic physical limits will be reached in the conventional two-dimensional design approach to semiconductor device design. Traditionally, Dynamic Random Access Memory (DRAM) designers have met the severest of challenges in advancing technologies by pushing the limits of feature size resolution with each generation of DRAM. For example, designers of 64K bit DRAMs were perplexed to learn that a practical physical limit to charge capacity of storage capacitors in planar cell layouts had already been reached due to the minimum charge capacity required to allow reliable data signal sensing in the presence of naturally occurring atomic particle radiation inherently present in fabrication materials and the operating environment. Storage capacitors in the range of about 50 fF were considered to be a physical limit. From a practical view, this limitation prevented a continuation of the scaling of DRAM dimensions and voltages initiated in the early 1980s.

Reduction in the surface area of semiconductor substrate utilized by the DRAM storage capacitor has been severely restricted. Due to deceases in the thickness of reliable capacitor dielectric materials, existing 1 Megabit (1Mb) DRAM technologies continue to enjoy the freedom of planar, two-dimensional device and circuit design. Beginning with 4Mb DRAMs, the world of three-dimensional design has been utilized to the extent that the simple single device/capacitor memory cell has been altered to provide the capacitor in a vertical dimension. In such designs, the capacitor has been formed in a trench formed in the surface of the semiconductor substrate. In yet denser designs, other forms of three-dimensional capacitors have been proposed, such as stacking the plates of the capacitor above the transfer device. Such designs, however, present difficulties in forming the interconnections to the required word access and data bit lines to the DRAM memory cell. Additional designs have been proposed in which the transfer device and its associated capacitor are both formed within a trench of preferably minimum feature size. Currently, insurmountable processing difficulties make such designs impractical for product manufacturing processes.

A large number of proposals for 16Mb and greater density DRAM cell designs have avoided continuing development of trench cell technology because of the existence of charge leakage mechanisms known to be present in trench capacitor structures. As these leakage mechanisms have become known, extensions of trench DRAM cells designs have been used successfully in 16Mb designs.

The following references describe various aspects of prior art techniques used in DRAM and other semiconductor technologies.

The article "Trench and Compact Structures for DRAMs" by P. Chatterjee et al., International Electron Devices Meeting 1986, Technical Digest paper 6.1, pp. 128-131, describes variations in trench cell designs through 16Mb DRAM designs, including the Substrate Plate Trench (SPT) cell described in more detail in U.S. Patent 4,688,063 issued August 18, 1987 to Lu et al. and assigned to the assignee of the instant invention. The SPT cell uses a highly conductive substrate as the DRAM cell plate. The storage node of each cell is formed in a deep trench in the substrate. U.S. Patent 4,801,988 issued January 31, 1989 to Kenney describes an improved SPT cell which includes a thick isolation region formed within the trench to enable higher density packing of DRAM cells. The article "CMOS Semiconductor Memory Structural Modification to Allow Increased Memory Charge" anonymous, IBM Technical Disclosure Bulletin, Vol. 31, No. 11, April 1989, pp.162-5, teaches a method of isolating the substrate plate of an SPT cell from support devices by providing a buried region under support devices in order to allow the plate reference voltage to be separately biased at an optimum Vdd/2 volts.

U.S. Patent 4,912,054 issued March 27, 1990 to Tomassetti describes methods of isolating bipolar-CMOS circuit devices through the use of various epitaxial layers as commonly found in bipolar device technologies. The article "A 45-ns 16-Mbit DRAM with Triple-Well Structure" by S. Fujii et al., IEEE Journal of Solid-State Circuits, Vol. 24, No. 5, October 1989, pp. 1170-1175, describes techniques for isolating various different functional device types in which the entire array of trench DRAM cells is formed within a surface implanted P-well.

U.S. Patent 4,829,017 issued May 9, 1989 to Malhi describes a method of forming a buried doped layer in a substrate by forming a shallow trench, protecting its sidewalls, further extending the trench and finally doping the walls of the extended trench to form a continuous doped region useful as the storage node of a trench DRAM.

The article "New Well Structure for Deep Sub-micron CMOS/BiCMOS Using Thin Epitaxy over Buried Layer and Trench Isolation" by Y. Okazaki et al., 1990 Symposium on VLSI Technology, Digest of Technical Papers, paper 6C-4, pp. 83-4, describes the use of buried epitaxial layers to isolate surface devices from the substrate.

Patent Abstracts of Japan, vol. 13, no 218; & JP-A-1 030 259 describes a method wherein an insulating film is provided between a supporting substrate and an element substrate to enable the use of a (1/2) V_{cc} method and make a capacitor. An insulating layer of silicon oxide or silicon nitride is formed on a supporting substrate of a P-type silicon, a semiconductor layer is deposited thereon, a field oxide film is provided, and a trench is formed through the usual trench etching. A capacitor insulating film of silicon oxide is formed on an inner wall of the trench and the surface of the semiconductor layer through the thermal oxidation, polycrystalline is embedded for the formation of a polycrystalline silicon layer. Next the insulating film is removed, the polycrystalline silicon layer is newly embedded, a silicon oxide film (gate oxide film) is provided, and a charge storage section is formed.

US-A-4 967 248 discloses a structure of a semiconductor memory cell with a trench-type capacitor. For increasing a retaining time period of a data bit, there is disclosed a semiconductor memory cell comprising a switching transistor and a storage capacitor fabricated in a semiconductor substrate formed with a heavily doped layer and a lightly doped layer, a transition layer graded in impurity atom concentration is produced between the heavily doped layer and the lightly doped layer, and the storage capacitor comprises (a) a first electrode formed by a first side wall portion of the lightly doped layer, a second side wall portion of the heavily doped layer and a bottom wall portion of the heavily doped layer, (b) a dielectric film formed in the first and second side wall portions and the bottom wall portion and defining a trench and (c) a second electrode wherein the dielectric film has a relatively thick portion which covers the transition layer so as to reduce the strength of electric field around the transition layer.

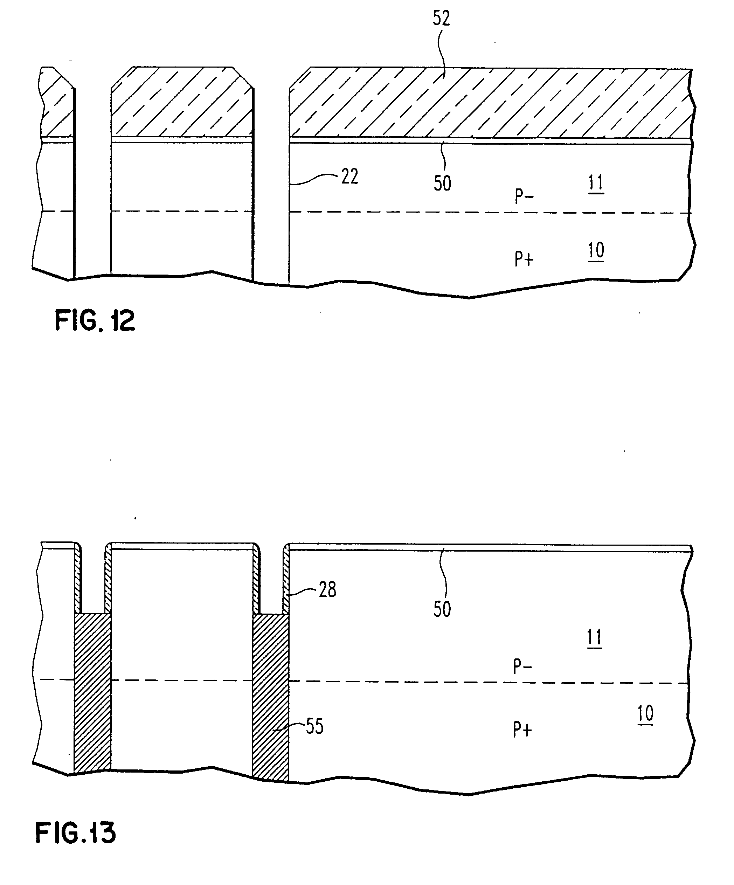

The following references relate specifically to variations in SPT DRAM ceLls in which a buried region of opposite conductivity type from the substrate is used a one plate of the DRAM storage capacitor. U.S. Patent 4,918,502 issued April 17, 1990 to Kaga et al. describes a buried plate trench DRAM cell in which the storage node of the cell and a sheath plate are formed in a single trench. At the bottom of the trench a diffusion of opposite type from the substrate is formed such that the diffusions of adjacent cells interconnect forming a grid-like structure. One or more trenches not associated with a DRAM cell is formed to act as a reach through to enable the doped region to be biased at a suitable reference voltage. Figure 12, thereof, clearly illustrates the grid-like aspect of the buried region. European published application 0 283 964, published September 28, 1988 describes a buried plate SPT DRAM cell in which an out-diffused region from the DRAM trenches, similar to that in Kaga et al., in which the diffused region forms the plate of the SPT cell. As in Kaga et al. a grid-like region is formed and is contacted by a non-cell trench. U.S. Patent 4,873,560 issued October 10, 1989 to Sunami et al, describes yet another buried plate SPT cell in which the access transistor is formed in the cell trench. FIG. 30, thereof, and its related text, describes the importance of maintaining the grid-like structure of the buried region in order to enable proper operation of the cell transfer device. Sunami et al, further cautions that in the event that opening in the grid-like buried region should be "filled by the depletion layer" isolating the surface devices from the substrate a separate connection can be made to the "isolated" surface region in order to bias it to the same potential as the substrate. UK Patent Application GB 2 215 913 A, published September 27, 1989 describes yet another variation in the buried SPT DRAM cell design in which the dopant for the buried region is provided by ion implantation into the sidewalls of the deep trench of the DRAM cell. Finally, U.S. Patent 4,794,434 issued December 27, 1988 to Pelley, describes a buried plate SPT DRAM cell formed using bipolar device processing methods in which the buried plate region is formed from a buried sub-collector structure normally part of a bipolar transistor.

While the above cited references illustrate the diverse and concentrated efforts made by DRAM designers in attempting to overcome the inherent barriers in continuing to reduce the size, and increase the density, of DRAM cells, none provide the capability to carry DRAM technology into the sub-0.5 µm feature size range, a feat which must be achieved in order to continue the two decade "tradition" of providing ever increasing density of DRAM technology. DRAM designers have turned to the process-complicating use of "stacked capacitor" DRAM cells knowing that the addition of processing steps decreases the manufacturability of a specific design.

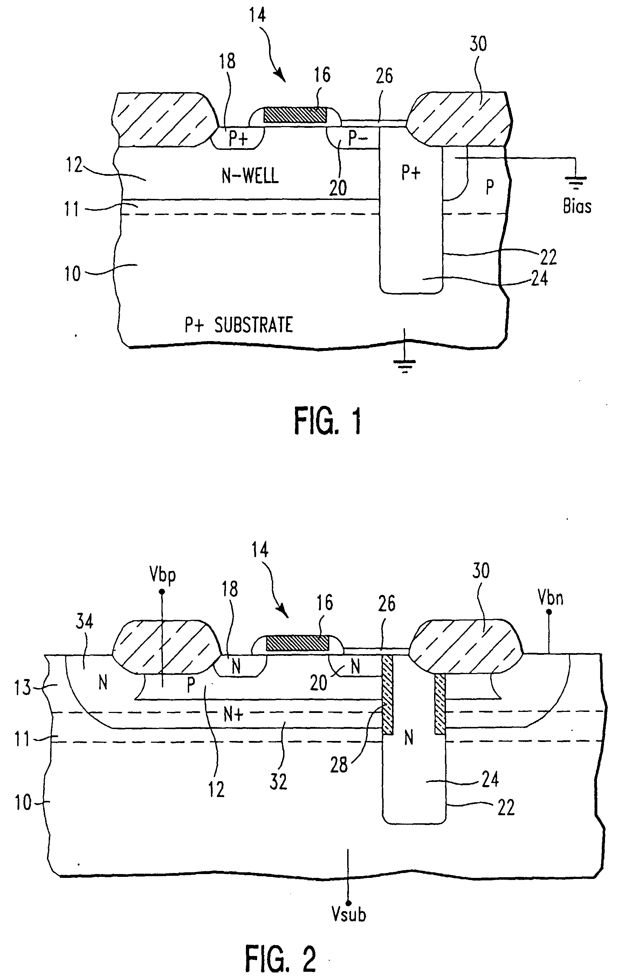

Referring to FIG. 1, there is shown a schematic cross-sectional view of the basic Substrate Plate Trench (SPT) DRAM cell described in U.S. Patent 4,688,063 to Lu et al. entitled "Dynamic RAM Cell with MOS Trench Capacitor in CMOS". A P+ type semiconductor substrate 10 is provided with a lightly doped epitaxial surface layer 11 in which is provided N-type retrograde implanted well 12 formed at its upper surface in which the transfer device 14 is formed. A control gate electrode 16 is responsive to signals from word line circuitry to couple data signals applied to the bit or data line diffused region 18 to the diffused storage node region 20. A deep trench 22 is provided in which a storage capacitor is formed. A polysilicon storage node plate 24 is formed in the trench and isolated from the substrate 10 by a thin storage node dielectric, not shown. A conductive strap 26 connects the diffused node 20 to the plate 24.

Manufacturing experience has shown that the SPT DRAM cell described is not suitable for extension to greater than 16 Mbit applications due in part to the performance limitations of P-array transfer devices and the existence of a parasitic device formed by the diffused storage node 20, the polysilicon plate 24 and the substrate 10. Simple conversion to N-type transfer devices is not practical and reduction of electrical stress on the capacitor dielectric by using Vdd/2 reference node biasing is not possible. The subject invention addresses the unsolved problems of the prior art by providing a solution to barriers presented in extending the manufacturability of the simple SPT cell to 64 Mb DRAM and beyond.

An object of the invention is to provide a SPT cell in which the density limitations of the prior art are removed.

Another object of the invention is to provide a Substrate Plate Trench DRAM design which does not increase process complexity at the expense of product yield.

Yet another object of the invention is to provide an SPT DRAM cell which has a minimum impact on existing processing technologies.

These objects are achieved by a DRAM device and corresponding method as claimed in claims 1 and 7 respectively. Further embodiments of the present invention are set out in the dependent claims.

These and other objects and features of the invention will become more fully apparent from the several drawings and description of the preferred embodiments.

Ways of carrying out the invention are described in detail below with reference to drawings showing only specific embodiments in which:
- FIG. 1: is a simplified schematic sectional view of a substrate plate trench (SPT) DRAM cell of the prior art illustrating the basic electrical connections of the cell.
- FIG. 2: is a simplified schematic sectional view of the double grid substrate plate trench (SPT) DRAM cell of the invention illustrating the basic electrical connections of the cell.
- FIGs. 3-10: are schematic sectional views of the array of the double grid substrate plate trench (SPT) DRAM cell illustrating the array at various steps in a preferred manufacturing process.
- FIG. 11: is a simplified schematic sectional view of the double well substrate plate trench (SPT) DRAM cell of the invention illustrating the basic electrical connections of the cell.
- FIGs. 12-19: are schematic sectional views of the array of the double well substrate plate trench (SPT) DRAM cell illustrating the array at various steps in a preferred manufacturing process.

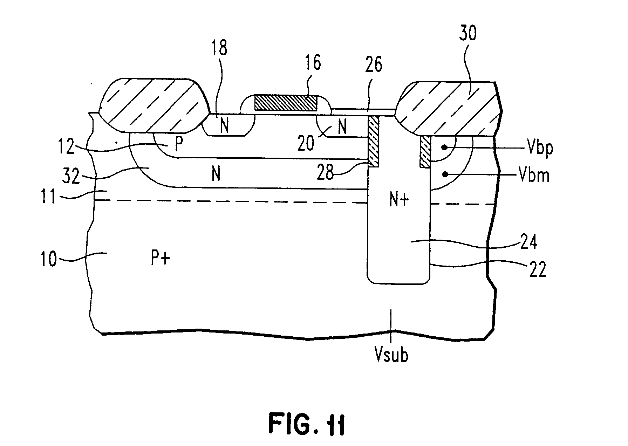

Referring to FIGs. 2 and 11, there are shown the basic elements of the double well Substrate Plate Trench DRAM cell of the invention. The cell is an improvement of the prior art SPT DRAM cell as described by Lu et al. in U.S. Patent 4,688,063 and as modified by Kenney in U.S. Patent 4,801,988, both of which are incorporated herein by reference. The cell includes the following major features. A substrate 10 of P+ type semiconductor material has an upper epitaxial layer of P-type material, as in the prior art. Referring to Fig. 2, using bipolar sub-collector fabrication technology, a first epitaxial layer 11 can be formed, followed by the localized formation of an N-type buried layer 32 and an additional P-type epitaxial layer 13. Surface diffused reach through regions 34 connect to the perimeter of the buried layer 12 such that the substrate region 12 in which the DRAM cells are formed becomes both physically and electrically isolated from the semiconductor substrate 10. Referring now to FIGs. 2 and 11, a P-type isolated region 12 or well 12 is formed at its upper surface into which N-channel transfer devices 14 are formed. A control gate electrode 16 of device 14 is responsive to a word access line of the DRAM array support circuits, not shown, to couple data between data or bit line diffused N-type region 18 and diffused N-type storage node region 20 through the channel region formed in region 12 or well 12. In a manner similar to the prior art, a storage capacitor is formed in a deep trench 22 adjacent to the storage node 20 and includes a signal storage node formed by conductive N-type polysilicon electrode 24 isolated from substrate 10 by a thin dielectric layer. Diffused surface storage node 20 and signal storage node 24 in the trench 22 are connected by a conductive strap 26. At the top of the storage trench a thick insulating collar 28 is provided to increase the threshold voltage of the vertical parasitic FET formed by the diffused storage node 20 and the substrate within the P-region 12. In order to eliminate the trench gated-induced diode leakage mechanism, in FIG. 2 of the double grid SPT DRAM cell the collar 28 must extend down the sidewall of trench 22 to a point below the lowermost pn junction of N-region 32. In FIG. 11 of the double well SPT Dram cell the collar 28 must extend below the N-well 32. Local surface isolation 30 is also provided, as is well known in the prior art.

It will be recognized that the cell features of Fig. 11 just described, with the exception of the substrate type, are similar to the N-channel variant of the prior art SPT DRAM cell. However, a second well or buried region 32 of N-type impurity type is addi-tionally provided to provide physical and electrical isolation to enable the independent biasing of the reference voltage node for the trench capacitor. Unlike prior art substrate plate trench DRAM cells, the buried region 32 of the invention forms an electrical and physical isolation means between the surface well 12 in which the transfer devices are formed and the semiconductor substrate 10 in which one or more DRAM cell arrays and support circuits are formed. Thus, buried region 32 and its two p-n junctions provide a means to independently bias, by way of Vsub, not only the plate reference voltage of the cells, but also the local substrates of both N- and P-channel devices used in support devices and the transfer devices 14 of the DRAM cells. It will be recognized that the buried layer voltage can be biased by Vbn to provide optimum isolation between the buried reference electrode and the P-well in which the active devices are to be formed.

It is an important aspect of the invention to provide arrays of cells as described in connection with FIGs. 2 and 11 in a simple easy to manufacture processing sequence. Because the basic SPT cell is effectively placed inside a P-well which is contained in an N-well, the additional processing steps necessary to fabricate the invention are minimized. To prevent gated-diode leakage due to the trench cutting through the wells in the double well SPT DRAM cell of Fig. 11, a dielectric collar 28 is placed around the top of the deep trenches. Typically, the P-well 12 can be biased at about -1 volt, the P+ substrate 10 at a level between ground and Vdd and the N-well 32 at a potential greater than or equal to the substrate potential Vsub.

The following key points describe key relationships available to the double grid SPT DRAM cell of FIG. 2 of the invention due to the ability to independently bias the several pn junction-isolated regions:
- 1.: By biasing regions 32/34 positively with respect to region 12, the substrate region of the transfer device 14, vertical sidewall trench parasitic FET subthreshold leakage and other leakage mechanisms along the trench sidewall will be collected on the electrode Vbn of N-type regions 32/34, instead of the storage node, region 20, of the transfer device improving retention time over the PRIOR ART cell (FIG.1);
- 2.: By biasing regions 32/34 positively with respect to region 12, minority carrier generation in region 12 and injection from data line diffused region 18 will be collected on the electrode Vbn of N-type regions 32/34, instead of region 20, improving retention time over the PRIOR ART (FIG.1);
- 3.: By biasing regions 32/34 positively with respect to semiconductor substrate region 10, in the case where deep collar structure region 28 is above or below N+ region 34 lower edge, leakage current along the trench dielectric sidewall of trench capacitor structure region 22 (generated in region 10) and carrier generation in the bulk of region 10 is collected on the electrode Vbn of region 34, instead of region 12, improving well voltage drops over PRIOR ART (FIG.1); and
- 4.: By isolation of region 12 from semiconductor substrate region 10 using N-type regions 32/34, independent bias conditions allow for different back-bias conditions for the n-channel MOSFET devices in region 12 and in peripheral surface P-type region 13 improving design point flexibility not possible in PRIOR ART (FIG. 1).

If one chooses to fabricate N-channel support FETs directly in the surface of the epitaxial layer 13, then a Vsub of 0 volts is advantageous. Additional advantages over the prior SPT cells which might not be readily apparent include the use of N-channel transfer devices providing faster I/O operations of the DRAM cell, providing isolation of all of the array transfer devices by the double pn junctions between regions 12 and 32 and 32 and 11 and enabling the substrate to be biased to reduce the stress across the storage node dielectric.

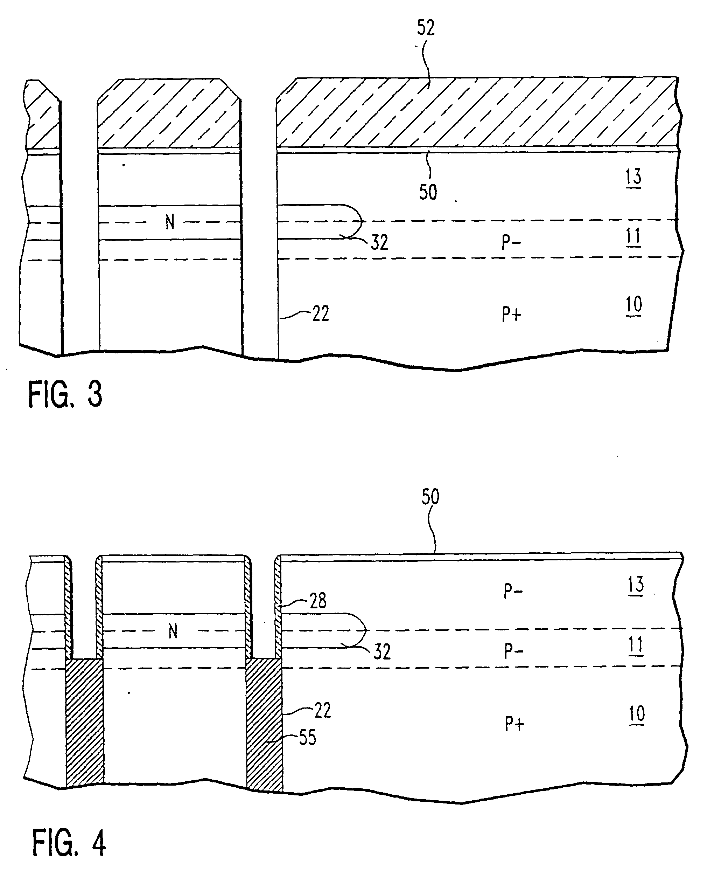

Reference is now made to FIGs. 3-10 and 12-19 which describe the preferred process sequence used to fabricate the double grid substrate plate trench DRAM cell array, and the double well substrate plate trench DRAM cell array.

Referring to FIG. 3, starting with a heavily doped P+ type semiconductor wafer 10, a lightly doped p-epitaxial layer 11 having a thickness of about 0.25 µm is provided. Next, heavily doped N-type regions 32, preferably using arsenic as the dopant impurity, are formed by a simultaneous out-diffusion and epitaxial growth step to form lightly doped layer 13 having a thickness of about 2.5 µm. On the upper surface of epitaxial layer 13 an oxide/nitride layer 50 having a thickness of about 175nm is formed on substrate 10 to act as an etch/polish stop to be used in subsequent steps.

Referring to FIG. 12, starting with a heavily doped P+ type semiconductor wafer 10, having a lightly doped p-epitaxial layer 11 on its upper surface, an oxide/nitride layer 50 having a thick-ness of about 175nm is formed on substrate 10 to act as an etch/polish stop to be used in subsequent steps.

Referring now to FIGs. 3 and 12, a relatively thick, about 500nm, layer 52 of oxide is deposited by a conventional CVD TEOS technique to act as an etch mask for trenches 22. A photolithographic mask is formed using a high resolution photoresist and is used to define the pattern of trenches 22 which are to be etched in substrate 10. The mask pattern is transferred to the thick oxide layer 52 and the oxide/nitride layer 50 by a dry plasma etching process using oxygen and carbon tetrafluoride (CF4) as the active agents. After stripping the photoresist, trenches 22' are etched to a depth of about 5.0 µm using a anisotropic RIE process to provide the structure shown in FIG. 3. It should be noted that the bottom of the etched trenches are not shown as a matter of convenience in describing the invention.

Next, as shown in FIGs. 4 and 13, the trench capacitor structure is formed by thermally oxidizing the now exposed silicon sidewalls and bottom of the trenches to a thickness of about 4nm. Then, about 7nm of silicon nitride is conformally deposited. The nitride layer is then oxidized to form about 1.5nm silicon dioxide to complete the ONO cell node dielectric. The trenches are then filled by conformally depositing polysilicon doped to at least 10¹⁹ atoms/cm² (1E19 atoms/cubic centimeter) to a thickness of about 900nm above the surface of the substrate. A thermal anneal step at about 1000 °C. in nitrogen heals any inadvertent seams formed in the polysilicon in the deep trenches 22. A polysilicon RIE process selective to silicon dioxide and silicon nitride then removes all of the polysilicon on the planar areas of the substrate and etches into the polysilicon at the tops of the trenches to a level of about 1.5 µm below the surface of the substrate leaving doped polysilicon 55 in the bottom of the trenches. The trench collar 28 is then formed on the sidewalls of the exposed trench tops by conformally depositing a layer of about 90nm of CVD silicon dioxide and then anisotropically etching the oxide from planar areas, including the bottoms of the trenches, to leave a collar 28 on the upper sidewalls of the recessed trenches in a manner similar to that in U.S. Patent 4,801,988. The resulting structure is shown in FIGs. 4 and 13.

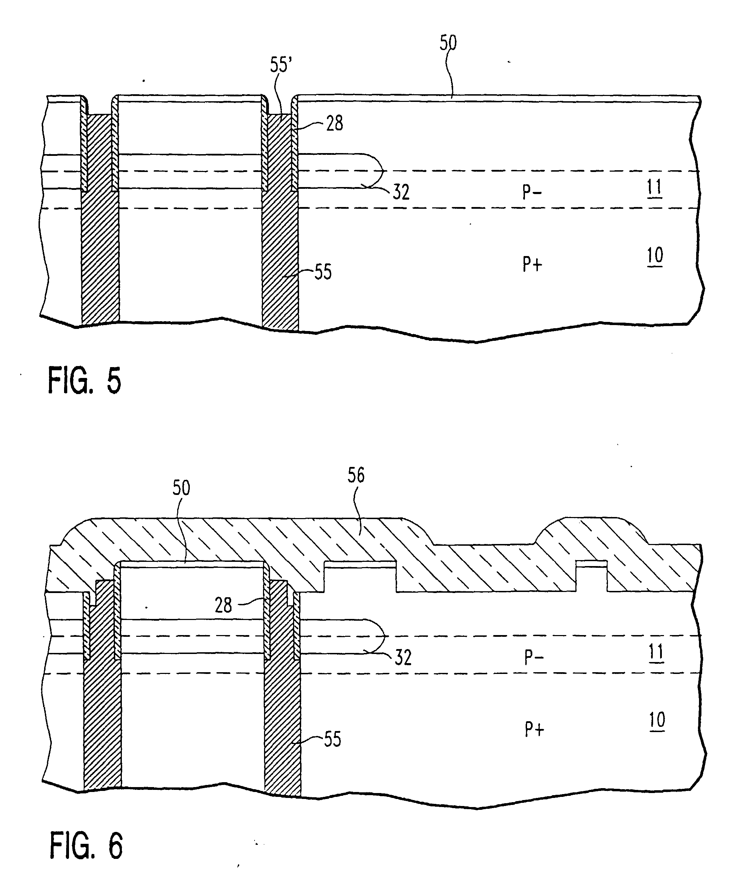

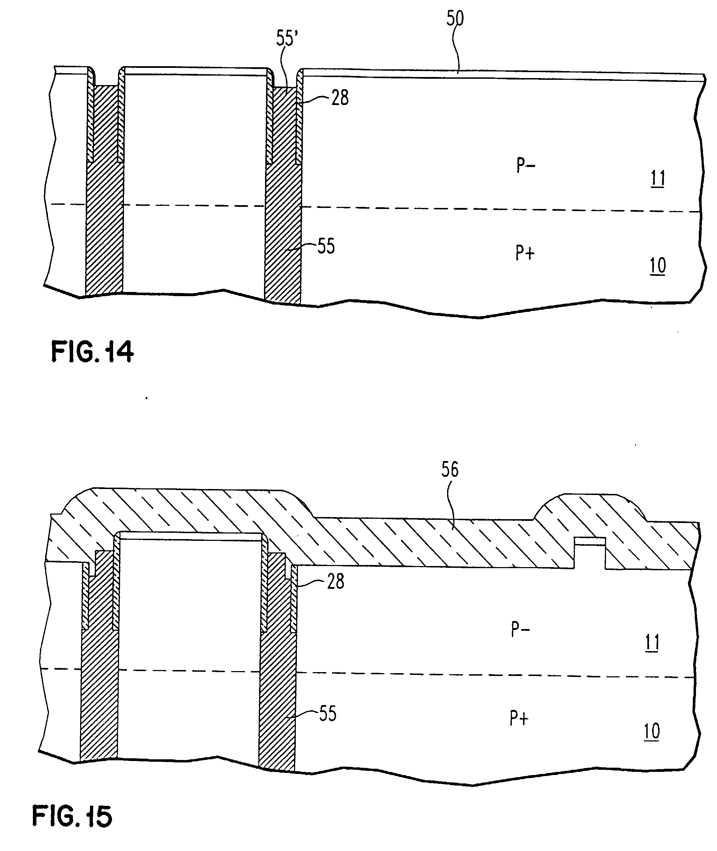

Referring now to FIGs. 5 and 14, the trenches are again filled with arsenic doped polysilicon to a surface thickness of about 600nm and annealed, as above. Then all of the thus deposited polysilicon formed on the back side of the substrate is removed preferably by a planarizing process such as chemical-mechanical polishing in order to reduce any undesirable stress caused by this non-functional layer. The front, or trench containing side, of the substrate is then planarized to remove the last deposited 600nm of polysilicon from all planar surfaces. In order to achieve superior planarity, it is preferable to use a chemical-mechanical polishing technique. Such techniques are described in greater detail in U.S. Patent 4,994,836 to Beyer et al. and U.S. Patent 4,789,648 to Chow et al. Next, polysilicon 55' in the top of the trenches is recessed about 50nm to 100nm below the substrate surface in order to prevent subsequently applied polysilicon word lines from shorting to the signal storage node of the trench capacitors. The resulting structure is shown in FIGs. 5 and 14.

Next the local isolation in the form of shallow trench isolation (STI) is formed, shown in FIGs. 6 and 15. An STI mask is applied to the substrate and defines all of the regions where STI is desired. The exposed oxide/nitride etch stop layer 50 is etched to expose the silicon substrate surface and overlapped polysilicon filled trench tops. Preferably in the same processing chamber, the exposed substrate, trench collar and polysilicon are etched to a depth of about 350nm. A LPCVD TEOS oxide layer 56 of about 630nm is then conformally deposited over the entire substrate as shown in FIGs. 6 and 15.

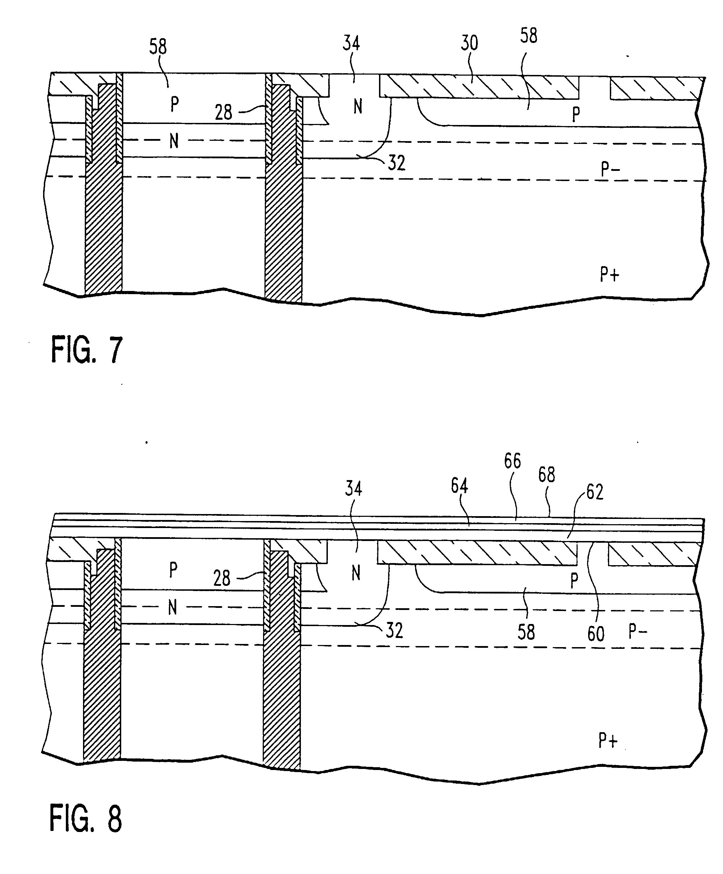

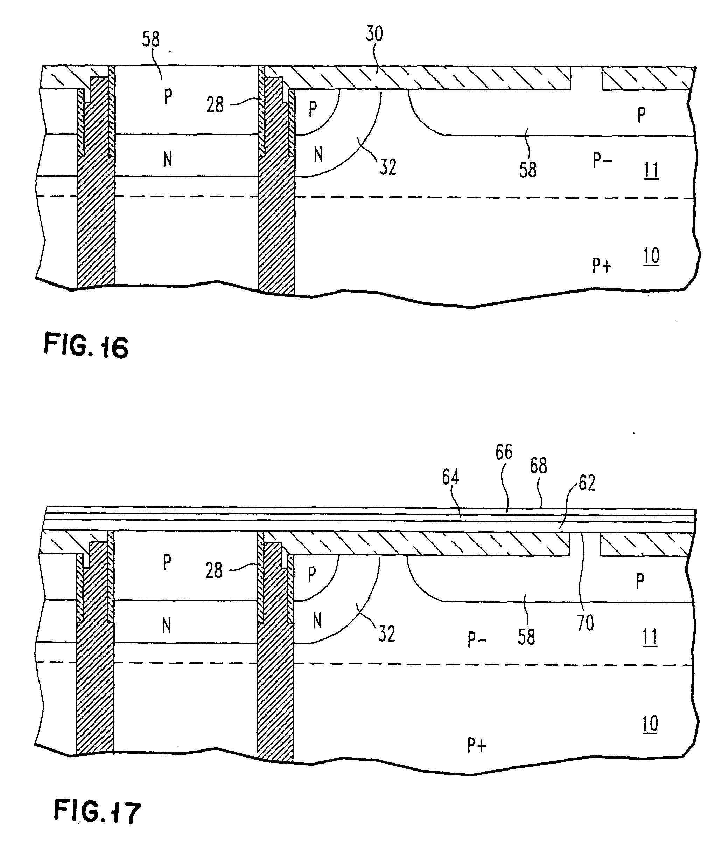

Next, as shown in FIGs. 7 and 16, STI oxide layer 56 is planarized, preferably by a combination of RIE etch-back and chemical-mechanical polishing as described in application 07/427,153 filed October 25, 1989 entitled "Forming Wide Dielectric Filled Trenches in Semiconductors" by Kerbaugh et al. Next, any remaining oxide/nitride layer 50 is removed by hot phosphoric acid and buffered HF. At this point, a sacrificial oxide may be grown on the exposed substrate surfaces, as these will become the active device areas for N- and P-channel devices of the CMOS process into which the array of the invention is integrated.

Referring to FIG. 7, next, N-wells for P-channel devices and for providing the buried N-type region 34 are formed by the conventional use of an N-well mask which covers all of the substrate except where N-wells are desired. It will be recognized that additional processing steps may be used to form the reach through region 34 as a separate operation, if desired.

Referring to Fig. 16, next, N-wells for P-channel devices and for providing the buried N-type well region 32 are formed by the conventional use of an N-well mask which covers all of the substrate except where N-wells are desired. After formation of the N-well mask, the substrate is exposed to a plurality of ion implantation steps to form retrograde N-wells 34 and 32. Phosphorus ions are implanted at about 900 KEV with a dose of about 5·10¹⁵ atoms/cm² (5E13 atoms per square centimeter) to form the higher concentration deepest portion of the well, at about 500 KEV with a dose of about 2,3·10¹² atoms/cm² (2.3E13 atoms per square centimeter) to form the bulk of the well, and at about 150 KEV with a dose of about 1,9·10¹² atoms/cm² (1.9E12 atoms per square centimeter) to control punch through. If desired an additional N-well mask can be used at this point to selectively implant arsenic at about 80 KEV with a dose of about 1,3·10¹² atoms/cm² (1.3E12 atoms per square centimeter) to control the threshold voltage of the P-channel FETs formed in selective N-wells. Additional implant masks and implants may also be used to further tailor specific device threshold voltages.

Following the formation of the N-wells, a conventional P-well mask is formed in a similar manner in order to mask the substrate against boron ions used to form the P-wells 58, also shown in FIGs. 7 and 16. To form the P-wells, boron ions are implanted at about 200 KEV with a dose of about 8·10¹² atoms/cm² (8E12 atoms per square centimeter) to form the bulk of the well, at about 80 KEV with a dose of about 1,6·10¹² atoms/cm² (1.6E12 atoms per square centimeter) to control punch through region and at about 7.3 KEV with a dose of about 3,7·10¹² atoms/cm² (3.7E12 atoms per square centimeter) to control the threshold voltage of the N-channel FETs used in the array and support circuitry of the DRAM. Thus, the structures in FIGs. 7 and 16 result. It will be clear from the above description, that the N-well regions 32 make physical contact with the substrate epitaxial layer 11 and the P-wells 58 in order to physically and electrically isolate the P-region 58 and 11, including P+ substrate 10. Unlike the prior art, there is no need to ensure that the substrate regions of the transfer devices can be electrically coupled to the semiconductor substrate 10.

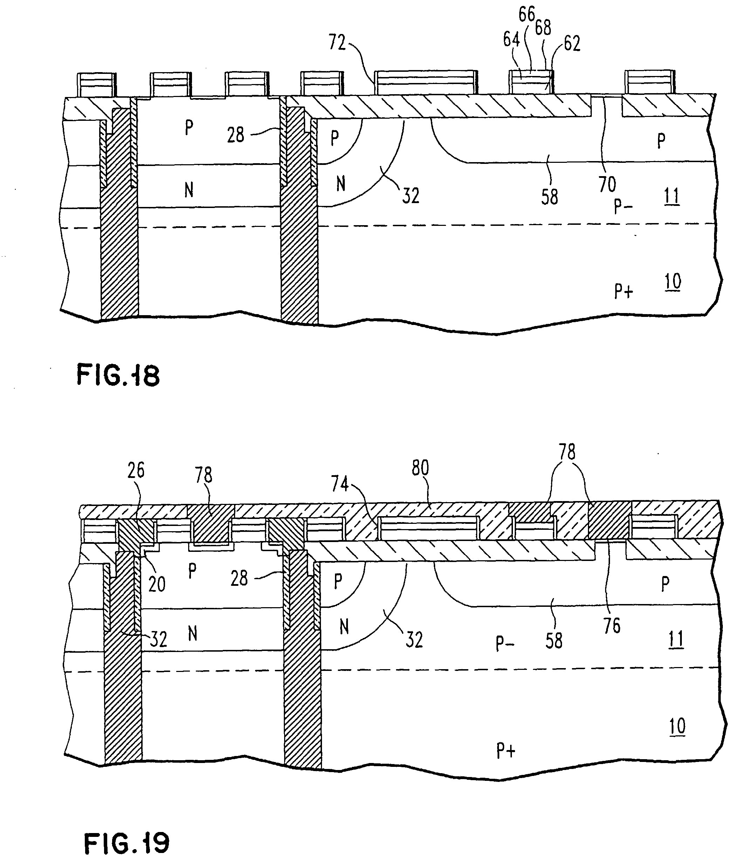

Next, the gate stack structure comprising the gate insulator, a conductive gate and a silicon nitride cap is formed as shown in FIGs. 8 and 17. After stripping the sacrificial oxide referred to above, a gate insulator layer 60 is formed by growing about 10nm of silicon dioxide on the exposed silicon surfaces of the substrate. A polysilicon layer 62 of about 200nm is deposited and doped by ion implanting phosphorus at about 25 KEV with a dose of about 6·10¹⁵ atoms/cm² (6E15 atoms per square centimeter). This is followed by deposition of about 100nm of titanium silicide layer 64 by sputtering to reduce the resistivity of the wordlines. The gate stack is completed by depositing a layer 66 of silicon dioxide and a layer 68 of silicon nitride of about 80nm resulting in the structure shown in FIGs. 8 and 17.

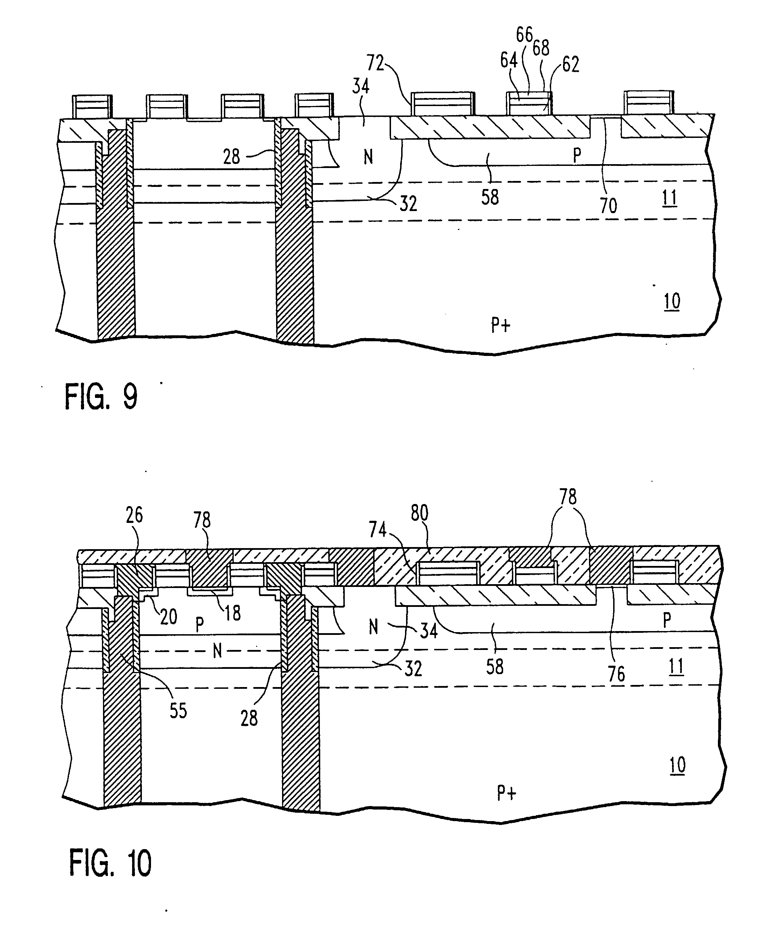

As shown in FIGs. 9 and 18, the multilayered gate stack is selectively etched to define the first level of interconnect and the gate electrodes for the CMOS FET devices to be formed on the planarized substrate. The exposed polysilicon is oxidized slightly at about 1050 °C. Next, a blocking mask is used to protect all of the device regions except where N-channel FETs are to be formed. A lightly doped N-type region 70 is then formed by implanting phosphorus at about 30 KEV with a dose of about 10¹⁴ atoms/cm² (1E14 atoms per square centimeter). After removal of the blocking mask, a sidewall spacer 72 is formed by depositing about 45nm of CVD silicon nitride followed by an anisotropic RIE of nitride present on planar surfaces. Next, the doped regions are silicided in a conventional manner by evaporating about 20nm of cobalt, annealing at about 750 °C. and removing unreacted cobalt in dilute nitric acid.

The devices and DRAM structure are completed with the following steps illustrated with reference to FIGs. 10 and 19. A silicon nitride sidewall 74 is formed by depositing a layer of silicon nitride of about 15nm followed by an anisotropic RIE step. The N+-type diffusions 76 for NFET devices are formed, after placing a blocking mask to protect PFET regions, by implanting arsenic at about 50 KEV with a dose of about 5·10¹⁵ atoms/cm² (5E15 atoms per square centimeter) followed by a drive-in step in nitrogen at about 900 °C. The P+-type diffusions for PFET devices are formed, after placing a blocking mask to protect NFET regions, by implanting boron at about 10 KEV with a dose of about 5·10¹⁵ atoms/cm² (5E15 atoms per square centimeter). A polysilicon surface strap 26 is formed to connect the N-type diffusions forming the storage node region 20 to the polysilicon 55' at the tops of the deep trenches is formed by the use of a blocking mask exposing the storage node regions, selectively etching the oxide at the trench top, depositing N-type polysilicon and planarizing by a chemical-mechanical polishing process to leave polysilicon straps 26. Interconnects 78 of titanium nitride and tungsten are formed as borderless contacts and an interlevel passivating layer 80 of phosphorus-doped glass is deposited and planarized, again by chemical-mechanical polishing techniques. The DRAM is completed by providing a number of additional planarized interconnect levels, as required by the complexity of the circuits to be interconnected.

## Claims

1. A dynamic random access memory device comprising:
a semiconductor substrate (10) having a first region (11) of a first conductivity type;
at least one array of dynamic memory cells (14), each cell (14) comprising an access transistor coupled to a storage capacitor, the transistors of each memory cell (14) being formed within a second region (12) situated above said first region (11) in said semiconductor substrate (10), each access transistor having a control electrode (16), a data line contact (18), a storage node (20), and a channel region;
a plurality of signal storage capacitors (24) formed in a plurality of trenches (22) formed in said substrate (10), and extending through said first (11) and second (12) region each capacitor (24) including a signal storage node (24) and a reference voltage node separated by a dielectric insulator, the reference node being connected to said substrate (10) and the storage node of each capacitor being connected to a corresponding storage node (20) of one of said access transistors;
means (34) for physically and electrically isolating all of the channel regions of said access transistors within said one array from said first region (11) of said substrate (10), said isolating means comprising a buried region (32) of opposite conductivity type to said first region (11), a portion of said buried region (32) being formed laterally between said first and second regions, said a portion of said buried region (32) intersecting all of said trenches (22);
means for biasing said first (11), second (12) and buried (32) regions of said substrate (10) to first, second and third different reference voltages and
wherein the signal storage capacitor includes an insulating layer (28) within and at the top of each of said trenches (22) having a thickness greater than the thickness at the bottom of said trenches (22), the thicker portion of the insulating layer (28) in said trenches (22) extending down to at least the level of the bottom of said buried region (32) or to at least the level of the top of said buried region (32).

2. The dynamic random access memory device of claim 1 wherein said buried region comprises a doped well formed in said substrate (10) wherein the doped well extends beyond and below said second region and having a depth within said substrate (10) less than that of said trenches (22);

3. The dynamic random access memory device of any of the claims 1 to 2 wherein the buried region (32) has an impurity doping level which varies with depth from the surface of the substrate (10).

4. The dynamic random access memory device of any of the claims 1 to 3 wherein the impurity type of said first region (12) is P-type.

5. The dynamic random access memory device of any of the claims 1 to 4 wherein the dopant impurity of said first region (12) is boron and the dopant impurity in the buried region (32) is N-type.

6. The dynamic random access memory device of any of the claims 1 to 5 wherein the access transistors are N-channel FET devices.

7. A method of making a dynamic random access memory device comprising the steps of:
providing a semiconductor substrate (10) of a first conductivity type;
forming a buried region (32) of a second conductivity type over at least a portion of the area of said substrate (10);
forming an array of deep trenches (22) in a matrix pattern in the top surface of said substrate (10), each trench (22) penetrating into said substrate (10) and through said buried region (32);
forming a dielectric layer on the inside of said deep trenches (22) and filling said trenches (22) with a conductive electrode material;
ion implanting and diffusing around the perimeter of said array of trenches (22) a diffused region of said second conductivity type having a depth so as to physically and electrically isolate a portion of the substrate (10) within said matrix pattern above said buried region; and
forming within the isolated portion of the matrix pattern a plurality of semiconductor devices for coupling signals to and from said conductive electrode material within at least some of said deep trenches (22); the thicker portion of the insulating layer (28) in said trenches (22) extending down to at least the level of the bottom of said buried region (32) or to at least the level of the top of said buried region (32).
wherein the step of forming a dielectric layer (28) on the inside surfaces of said deep trenches (22) includes the step of forming a thick dielectric collar (28) at the top of said deep trenches (22), the dielectric collar extending down to at least the level of the bottom of said buried region (32) or to at least the level of the top of said buried region (32).

8. The method of making a dynamic random access memory device of claim 7 wherein the source of dopant material used to form said buried region (32) is N-type.

## Patentansprüche

1. Eine dynamische Speichervorrichtung, bestehend aus:
einem Halbleitersubstrat 10 mit einem ersten Bereich 11 eines ersten Leitungstyps;
mindestens einer Anordnung von dynamischen Speicherzellen 14, wobei jede Zelle 14 einen mit einem Speicherkondensator verbundenen Zugriffstransistor besitzt und der Transistor jeder Speicherzelle 14 in einem zweiten Bereich 12 gebildet wird, der über dem ersten Bereich 11 im Halbleitersubstrat 10 liegt, und wobei jeder Zugriffstransistor eine Steuerelektrode 16, einen Datenleitungskontakt 18, einen Speicherknoten 20 und einen Kanalbereich besitzt;
mehreren Signalspeicherkondensatoren 24, die in mehreren Gräben 22 im Substrat 10 gebildet werden und sich über den ersten Bereich 11 und den zweiten Bereich 12 erstrecken, wobei jeder Kondensator 24 einen Signalspeicherknoten 24 und einen Referenzspannungsknoten, die durch einen dielektrischen Isolator getrennt sind, besitzt, wobei der Referenzknoten mit dem Substrat 10 verbunden ist, und der Speicherknoten jedes Kondensators mit einem entsprechenden Speicherknoten 20 eines der Zugriffstransistoren verbunden ist;
Mitteln 34 zur physischen und elektrischen Isolierung aller Kanalbereiche der Zugriffstransistoren innerhalb der einen Anordnung gegenüber dem ersten Bereich 11 des Substrats, wobei das Isolierungsmittel einen überdeckten Bereich 32 besitzt, dessen Leitungstyp dem des ersten Bereichs 11 entgegengesetzt ist, und wobei ein Teil des überdeckten Bereichs 32 seitlich zwischen dem ersten und dem zweiten Bereich gebildet wird, so daß ein Teil des überdeckten Bereichs 32 alle Gräben 22 schneidet;
Mitteln zum Vorspannen des ersten Bereichs 11, des zweiten Bereichs 12 und des überdeckten Bereichs 32 des Substrats mit einer jeweils unterschiedlichen ersten, zweiten und dritten Referenzspannung,
wobei der Signalspeicherkondensator in jedem Graben 22 und an der Oberseite jedes Grabens 22 eine Isolierschicht 28 besitzt, deren Dicke größer ist als die Dicke am Boden der Gräben 22, wobei sich der dickere Teil der Isolierschicht 28 in den Gräben 22 mindestens bis zum Grund des überdeckten Bereichs 32 oder mindestens bis zur Oberkante des überdeckten Bereichs 32 erstreckt.

2. Eine dynamische Speichervorrichtung nach Anspruch 1, bei der der überdeckte Bereich eine dotierte Senke im Substrat 10 enthält, die nach oben und nach unten über den zweiten Bereich hinaus reicht und deren Tiefe im Substrat 10 geringer ist als die der Gräben 22.

3. Eine dynamische Speichervorrichtung nach Anspruch 1 oder 2, bei der der überdeckte Bereich 32 eine Dotierungsstärke besitzt, die mit der Tiefe von der Oberfläche des Substrats 10 variiert.

4. Eine dynamische Speichervorrichtung nach Anspruch 1 bis 3, bei der die Dotierungsart des ersten Bereichs 12 vom P-Typ ist.

5. Eine dynamische Speichervorrichtung nach Anspruch 1 bis 4, bei der das Dotierungsmittel des ersten Bereichs 12 Bor und das Dotierungsmittel um überdeckten Bereich 32 ein Dotierungsmittel des N-Typs ist.

6. Eine dynamische Speichervorrichtung nach Anspruch 1 bis 5, bei dem die Zugriffstransistoren N-Kanal-FETs sind.

7. Ein Verfahren zur Herstellung einer dynamischen Speichervorrichtung, bestehend aus folgenden Schritten:
Bereitstellen eines Halbleitersubstrats 10 mit einem ersten Leitungstyp;
Herstellen eines überdeckten Bereichs 32 mit einem zweiten Leitungstyp über wenigstens einem Teil der Fläche des Substrats 10;
Herstellung einer Anordnung tiefer Gräben 22 in einem Matrixmuster auf der Oberseite des Substrats 10, wobei jeder Graben in das Substrat 10 eingetieft ist und den überdeckten Bereich 32 durchdringt;
Herstellung einer dielektrischen Schicht auf der Innenseite der tiefen Gräben 22 und Auffüllen der Gräben 22 mit einem leitenden Elektrodenmaterial;
Ionenimplantierung und Diffusion eines diffundierten Bereichs des zweiten Leitungstyps im Umfangsbereich der Grabenanordnung mit einer Tiefe, die so gewählt ist, daß ein Teil des Substrats 10 innerhalb des Matrixmusters über dem überdeckten Bereich elektrisch isoliert wird; und
Herstellung mehrerer Halbleitervorrichtungen im isolierten Teil des Matrixmusters, um Signale von und zu dem leitfähigen Elektrodenmaterial in zumindest einigen der tiefen Gräben 22 zu koppeln; wobei der dickere Teil der Isolierschicht 28 in den tiefen Gräben 22 nach unten mindestens bis zum Boden des überdeckten Bereichs 32 oder nach oben mindestens bis zur Oberkante des überdeckten Bereichs reicht;
wobei der Schritt der Herstellung einer dielektrischen Schicht 28 an den Innenflächen der tiefen Gräben einen Schritt enthält, in dem im oberen Teil der tiefen Gräben 22 ein dicker dielektrischer Ring 28 gebildet wird, der sich nach unten mindestens bis zum Boden des überdeckten Bereichs 32 und nach oben mindestens bis zur Oberkante des überdeckten Bereichs 32 erstreckt.

8. Ein Verfahren zur Herstellung einer dynamischen Speichervorrichtung nach Anspruch 7, bei dem das zur Herstellung des überdeckten Bereichs 32 verwendete Dotierungsmittel zum N-Typ gehört.

## Revendications

1. Un dispositif mémoire à accès aléatoire dynamique, comprenant :
un substrat semi-conducteur (10) ayant une première zone (11) d'un premier type de conductivité;
au moins une matrice de cellules mémoires dynamiques (14), chaque cellule (14) comprenant un transistor d'accès couplé à un condensateur de stockage, les transistors de chaque cellule mémoire (14) étant formés à l'intérieur d'une deuxième zone (12) située au-dessus de ladite première zone (11) dans ledit substrat semi-conducteur (10), chaque transistor d'accès ayant une électrode de commande (16), un contact de ligne de données (18), un noeud de stockage (20) et une zone de canal;
une pluralité de condensateurs de stockage de signal (24) formés en une pluralité de sillons (22) ménagés dans ledit substrat (10), et s'étendant à travers lesdites première (11) et deuxième (12) régions, chaque condensateur (24) comprenant un noeud de stockage de signal (24) et un noeud de tension de référence séparés par un isolant diélectrique, le noeud de référence étant connecté audit substrat (10) et le noeud de stockage de chaque condensateur étant connecté à un noeud de stockage (20) correspondant de l'un desdits transistors d'accès;
des moyens (34), pour isoler physiquement et électriquement la totalité des régions de canal desdits transistors d'accès, dans ladite une matrice vis-à-vis de ladite première région (11) dudit substrat (10), lesdits moyens d'isolation comprenant une région noyée d'un type de conductivité opposé à celui de ladite région (11), une partie de ladite région noyée (32) étant formée latéralement entre lesdites première et deuxième régions, ladite une partie de ladite région noyée (32) coupant la totalité desdits sillons (22);
des moyens pour polariser lesdites première (11), deuxième (12) régions et la région noyée (32) dudit substrat (10) à des première, deuxième et troisième tensions de référence différentes, et dans lequel ledit condensateur de stockage de signal comprend une couche d'isolation (28) à l'intérieur et au-dessus de chacun desdits sillons (22), d'une épaisseur supérieure à l'épaisseur que l'on a au fond desdits sillons (22), la partie plus épaisse de la couche isolante (28) dans lesdits sillons (22) s'étendant vers le bas, vers au moins le niveau du fond de ladite région noyée (32) ou au moins le niveau du dessus de ladite région noyée (32).

2. Le dispositif mémoire à accès aléatoire dynamique selon la revendication 1, dans lequel ladite région noyée comprend un puits dopé formé dans ledit substrat (10), dans lequel le puits dopé s'étend au-delà et au-dessous de ladite deuxième région et ayant une profondeur, dans ledit substrat (10), qui est inférieure à celle desdits sillons (22).

3. Le dispositif mémoire à accès aléatoire dynamique selon l'une quelconque des revendications 1 à 2, dans lequel la région noyée (32) a un niveau de dopage par impureté qui varie en fonction de la profondeur depuis la surface du substrat (10).

4. Le dispositif mémoire à accès aléatoire dynamique selon l'une quelconque des revendications 1 à 3, dans lequel le type d'impureté de ladite première région (10) est de type P.

5. Le dispositif mémoire à accès aléatoire dynamique selon l'une quelconque des revendications 1 à 4, dans lequel l'impureté du dopant de ladite première région (12) est constituée de bore et l'impureté du dopant que l'on a dans ladite région noyée (32) est de type N.

6. Le dispositif mémoire à accès aléatoire dynamique selon l'une quelconque des revendications 1 à 5, dans lequel les transistors d'accès sont des dispositifs à transistor à effet de champ (FET) à canal N.

7. Un procédé de fabrication d'un dispositif mémoire à accès aléatoire dynamique, comprenant les étapes consistant à :
fournir un substrat semi-conducteur (10) d'un premier type de conductivité;
former une région noyée (32) d'un deuxième type de conductivité sur au moins une partie de l'aire dudit substrat (10);
former une matrice de sillons profonds (32) en adoptant un motif en matrice, dans la surface supérieure dudit substrat (10), chaque sillon (32) pénétrant dans ledit substrat (10) et dans ladite région noyée (32);
former une couche diélectrique à l'intérieur desdits sillons profonds (22) et combler lesdits sillons (22) avec un matériau d'électrode conductrice;
effectuer une implantation et une diffusion d'ions autour du périmètre de ladite matrice de sillons (22), d'une région diffusée dudit deuxième type de conductivité ayant une profondeur telle qu'elle isole physiquement et électriquement une partie du substrat (10) dans ledit motif en matrice situé au-dessus de ladite région noyée; et
former, à l'intérieur de la partie isolée du motif en matrice, une pluralité de dispositifs à semiconducteurs pour coupler des signaux vers et depuis ledit matériau d'électrode conducteur, à l'intérieur d'au moins certains desdits sillons profonds (22);
la partie plus épaisse de la couche isolante (28) dans lesdits sillons (22) s'étendant vers le bas, vers au moins le niveau du fond de ladite région noyée (32) ou au moins le niveau du dessus de ladite région noyée (32),
dans lequel l'étape de formation d'une couche diélectrique (28) sur les surfaces intérieures desdits sillons profond (22) comprend l'étape de formation d'une collerette diélectrique épaisse (28) en partie haute desdits sillons profonds (22), la collerette diélectrique s'étendant vers le bas vers au moins le niveau du fond de ladite région noyée (32) ou au moins le niveau du dessus de ladite région noyée (32).

8. Le procédé de fabrication d'un dispositif mémoire à accès aléatoire dynamique selon la revendication 7, dans lequel la source de matériau dopant utilisée pour former ladite région noyée (32) est de type N.
